# EUROPÄISCHE PATENTSCHRIFT

(11) **EP 1 677 588 B1**
(45) Veröffentlichungstag und Bekanntmachung des Hinweises auf die Patenterteilung: **02.07.2008**
(21) Anmeldenummer: 05111720.8
(22) Anmeldetag: 06.12.2005
(51) Int. Cl.: H05K 13/08

(54) **Optische Datenübertragung zwischen einem Bestückautomaten und einer Zuführeinrichtung**
Optical data transfer between mounting and feeding apparatus
Transferts optiques de données entre des appareils de montage et d'alimentation

(30) Priorität: 04.01.2005 DE 102005000743
(43) Veröffentlichungstag der Anmeldung: 05.07.2006
(73) Patentinhaber: SIEMENS AKTIENGESELLSCHAFT, 80333 München (DE)
(72) Erfinder: Pallas, Dirk, 86899, Landsberg (DE)

(56) Entgegenhaltungen:
- EP-A- 0 453 370
- DE-A1- 19 931 054

## Beschreibung

Die Erfindung betrifft einen Bestückautomaten, eine Zuführeinrichtung und ein Bestücksystem, welche derart ausgebildet sind, dass Daten optisch übertragbar sind, sowie ein entsprechendes Verfahren zur Datenübertragung.

Moderne industrielle Fertigungssysteme sind meist modulartig aufgebaut. So setzt sich beispielsweise ein Bestückautomat für Substrate in der Regel aus einem Hauptkörper bzw. einem Chassis, auf welchem sich die Transportstrecke für die Substrate, das Positioniersystem für den Bestückkopf sowie die zentrale Steuereinheit des Bestückautomaten befinden, und meist mehreren Zuführeinrichtungen, welche zur Bereitstellung der elektrischen Bauelemente seitlich der Transportstrecke an den Bestückautomaten angekoppelt werden, zusammen. Neben der zentralen Steuereinheit, die sich im Hauptkörper bzw. im Chassis des Bestückautomaten befindet, verfügen die Subsysteme, wie beispielsweise der Bestückkopf oder die Zuführeinrichtungen, eigene Steuereinrichtungen, welche von der zentralen Steuereinheit nur angesteuert werden, sonst aber autark arbeiten. Für den Datenaustausch, wie beispielsweise die Übermittlung des Vorschubzeitpunkts bzw. der Vorschubweite von der zentralen Steuereinheit an die Zuführeinrichtung, werden immer schnellere, zuverlässigere und kostengünstigere Datenübertragungssysteme gefordert.

Bei einem aus der Offenlegungsschrift EP-0453370 bekannten Bestückautomaten werden die Steuereinrichtungen der Zuführeinrichtung und die zentrale Steuereinheit des Bestückautomaten mittels einer elektrischen Steckverbindung miteinander verbunden. Mit dieser Steckverbindung ist auch gleichzeitig die Stromversorgung der Zuführeinrichtung sichergestellt.

Bei modernen Bestückautomaten ist es inzwischen möglich, eine sehr große Anzahl von Zuführeinrichtungen gleichzeitig nebeneinander an dem Bestückautomaten anzubringen. Der Verkabelungsaufwand, der sich aufgrund der elektrischen Steckverbindungen für den Benutzer ergibt, ist beträchtlich und fehlerbehaftet. So kann beispielsweise beim Wechseln einer Zuführeinrichtung das Herausziehen der Steckverbindung vergessen werden, wodurch es zu einem Abreißen der Steckverbindung kommen kann und somit zum Ausfall der Zuführeinrichtung. Da die Zuführeinrichtungen sehr geringe Breiten aufweisen können, müssen auch die Steckverbindungen immer schmaler werden, wodurch sich eine immer schlechtere Handhabbarkeit beim Ankoppeln und Entfernen der Zuführeinrichtungen ergibt.

In solchen industriellen Fertigungssystemen werden zunehmend Feldbussysteme für die Kommunikation zwischen den einzelnen Subsystemen eingesetzt. Der Einsatz dieser Systeme bringt eine Reihe von Vorteilen mit sich, wie beispielsweise einen verminderten Verkabelungsaufwand, eine erhöhte Zuverlässigkeit, vereinfachte Testbarkeit des Gesamtsystems und größere Störungssicherheit. Trotz des etwas verminderten Verkabelungsaufwands sind die oben genannten Nachteile auch bei der Verwendung von Feldbussystemen vorhanden.

Es ist deshalb die Aufgabe der vorliegenden Erfindung, einen Bestückautomaten, eine Zuführeinrichtung für elektrische Bauteile, ein Bestücksystem und ein Verfahren zur Datenübertragung zu liefern, welche eine verbesserte Handhabbarkeit gewährleisten.

Diese Aufgabe wird durch den Bestückautomaten, die Zuführeinrichtung, das Bestücksystem und das Verfahren gemäß den unabhängigen Ansprüchen gelöst. Vorteilhafte Ausgestaltungen sind Gegenstand der abhängigen Ansprüche.

Der Bestückautomat gemäß Anspruch 1 umfasst eine erste Steuereinrichtung, der ein erster CAN-Controller zugeordnet ist, einen ersten Protokoll-Wandlerbaustein, der mit dem ersten CAN-Controller elektrisch verbunden ist und derart ausgebildet ist, dass er CAN-Protokoll konforme Daten in IrDA-Protokoll konforme Daten und umgekehrt umwandeln kann. Der erste Protokoll-Wandlerbaustein ist mit einem ersten Infrarot-Sender und einem ersten IrDA-kompatiblen Infrarot-Empfänger elektrisch verbunden, so dass IrDA-Protokoll-konforme elektrische Daten als entsprechende optische Infrarot-Signale sowohl ausgesendet als auch empfangen werden können. Der erste Infrarot-Sender und der erste Infrarot-Empfänger sind dabei derart am Bestückautomat angeordnet, dass der erste Infrarot-Sender mit einem zweiten Infrarot-Empfänger einer Zuführeinrichtung für elektrische Bauteile und der erste Infrarot-Empfänger mit einem zweiten Infrarot-Sender der Zuführeinrichtung so optisch koppelbar sind, dass eine Datenübertragung möglich ist. Der so ausgebildete Bestückautomat bringt den Vorteil, dass durch die optische bzw. berührungslose Datenübertragung keine Steckverbindung zum Datenaustausch mit einer Zuführeinrichtung mehr nötig ist. Dadurch erhöht sich die Bedienerfreundlichkeit erheblich und die Gefahr einer Beschädigung einer elektrischen Steckverbindung ist eliminiert. Des Weiteren ist es möglich, die Vorteile der Datenkommunikation mittels CAN-Bus mit denen der optischen Datenübertragung zu vereinen, was aufgrund der Übertragungssicherheit weitere Vorteile bringt.

In einer vorteilhaften Ausgestaltung gemäß Anspruch 2 umfasst der Bestückautomat einen ersten Magnetkern, der mit einer Primärspule umwickelt ist, welche mit einer dem Bestückautomaten zugeordneten Spannungsquelle verbunden ist. Der erste Magnetkern ist derart am Bestückautomaten angeordnet, dass mit einem zweiten Magnetkern einer Zuführeinrichtung, welcher mit einer Sekundärspule umwickelt ist, koppelbar ist. Um einen sicheren Kontakt zwischen dem ersten und dem zweiten Magnetkern zu gewährleisten, ist der erste Magnetkern gegenüber dem Bestückautomaten federnd gelagert, so dass er im gekoppelten Zustand gegen den zweiten Magnetkern gedrückt wird und einander zugewandten Kontaktflächen der Magnetkerne mit möglichst geringem Spalt sicher aneinander liegen. Zur Gewährleistung einer möglichst starken Bündelung des magnetischen Felds bzw. einer guten Energieübertragung kann der Magnetkern aus einem Material mit hoher magnetischer Permeabilität (d.h. hoher Durchlässigkeit für magnetische Felder), beispielsweise aus Ferrit, gefertigt sein. Durch die induktive Energieübertragung kann auf eine elektrische Steckerverbindung verzichtet werden. Die induktive Energieübertragung ergänzt sich hervorragend mit der optischen Datenübertragung zwischen Bestückautomat und Zuführeinrichtung, da praktisch vollständig auf elektrische Steckerverbindungen verzichtet werden kann. Dadurch ergeben sich für den Bediener erhebliche Handhabungsvorteile beim Umrüsten der Zuführeinrichtung und ein Ausreißen eines Steckers ist nicht mehr möglich.

Eine weitere vorteilhafte Ausgestaltung gemäß Anspruch 3 ist dadurch gekennzeichnet, dass der federnd gelagerte erste Magnetkern zusätzlich drehbar gelagert ist. Dadurch wird gewährleistet, dass einander zugewandte Kontaktflächen des ersten und zweiten Magnetkerns im angedrückten Zustand immer parallel aneinander anliegen. Auf Seiten des Bestückautomats oder der Zuführeinrichtung kann es durch Wärmeverzug zu Verformungen in den Lagern der entsprechenden Magnetkerne kommen, was zur Bildung eines Spalts zwischen den Magnetkernen führen kann. Durch die drehbare Lagerung des ersten Magnetkerns können solche Verformungen jedoch ausgeglichen werden.

Eine Ausgestaltung des Bestückautomats nach Anspruch 4 zeichnet sich dadurch aus, dass der erste Magnetkern so schmal ausgeführt ist, dass er die Breite einer an den Bestückautomaten gekoppelten Zuführeinrichtung nicht überschreitet und dass er in Bereichen, in denen er mit der Primärspule umwickelt ist, zusammen mit der Primärspule die Breite der Zuführeinrichtung nicht überschreitet. Da Zuführeinrichtungen möglichst schmal ausgeführt werden, um auf dem vorgegebenen Raum möglichst viele davon am Bestückautomaten vorsehen zu können, ist der erste Magnetkern so schmal ausgebildet, dass er selbst zusammen mit der Primärspule nicht über die angekoppelte Zuführeinrichtung hinausragt. Dadurch kann ein niedriges Rastermaß der Zuführeinrichtung am Bestückautomaten erreicht werden.

In einer weiteren Ausgestaltung gemäß Anspruch 5 weist der erste Magnetkern die Gestalt des lateinischen Buchstaben "E" auf, wobei nur der mittlere Schenkel mit der Primärspule umwickelt ist. Diese Form des Magnetkerns erlaubt eine sehr effiziente Energieübertragung. Im gekoppelten Zustand berühren sich der erste Magnetkern des Bestückautomats und der zweite Magnetkern der Zuführeinrichtung jeweils an den freien Stirnflächen der drei Schenkel.

Darüber hinaus kann, gemäß einer weiteren vorteilhaften Ausgestaltung nach Anspruch 6 das die drei Schenkel verbindende Rückenteil des E-förmigen ersten Magnetkerns zumindest im Bereich der Verlängerung des mittleren Schenkels so schmal ausgebildet sein, dass es zumindest auf einer Seite des ersten Magnetkerns bündig mit dem mittleren Schenkel abschließt, um dort Anschlussleitungen der Primärspule führen zu können. Wie oben schon erwähnt, soll die Gesamtheit des ersten Magnetkerns mit der Primärspule die Breite einer an den Bestückautomaten gekoppelten Zuführeinrichtung nicht überschreiten. Um zu verhindern, dass die Zuführleitungen der Primärspule über die Zuführeinrichtung seitlich hinausragen, ist das die drei Schenkel verbindende Rückenteil des E-förmigen ersten Magnetkerns zumindest im Bereich der Verlängerung des mittleren Schenkels so schmal ausgebildet, dass dort die Anschlussleitungen der Primärspule geführt werden können. Somit kann auf Seiten des Bestückautomaten ein möglichst enges Rastermaß erster Magnetkerne erreicht werden, wodurch eine möglichst große Anzahl von Zuführeinrichtungen an den Bestückautomaten angebracht werden kann.

Eine Zuführeinrichtung gemäß dem Anspruch 7 ist zur berührungslosen Datenübertragung mit einem entsprechenden Bestückautomaten geeignet. Analog zum dem gemäß Anspruch 1 gekennzeichneten Bestückautomat umfasst die Zuführeinrichtung eine zweite Steuereinrichtung mit einem zweiten CAN-Controller, einen zweiten Protokoll-Wandlerbaustein, einen zweiten Infrarot-Sender und einen zweiten Infrarot-Empfänger. Der zweite Infrarot-Empfänger und der zweite Infrarot-Sender sind dabei derart an der Zuführeinrichtung vorgesehen, dass der zweite Infrarot-Empfänger mit einem ersten Infrarot-Sender eines Bestückautomaten und der zweite Infrarot-Sender mit einem ersten Infrarot-Empfänger des Bestückautomaten koppelbar sind.
Bezüglich der Vorteile wird auf Anspruch 1 verwiesen.

In einer Ausgestaltung der Zuführeinrichtung gemäß Anspruch 8 weist die Zuführeinrichtung ein Zuführeinrichtungsgehäuse und einen zweiten Magnetkern auf, der mit einer Sekundärspule, die ihrerseits mit einem der Zuführeinrichtungen zugeordneten Verbraucher elektrisch verbunden ist, umwickelt ist. Zu den Verbrauchern zählen beispielsweise Antriebsmotoren und Steuerelektronik. Der zweite Magnetkern ist dabei so angeordnet ist, dass er mit einem einem Bestückautomaten zugeordneten ersten Magnetkern, der seinerseits mit einer Primärspule umwickelt ist, koppelbar ist. Der zweite Magnetkern ist gegenüber dem Zuführeinrichtungsgehäuse federnd gelagert ist, so dass der zweite Magnetkern im gekoppelten Zustand gegen den ersten Magnetkern gedrückt wird. Diese Ausgestaltung der Zuführeinrichtung erlaubt eine induktive Energieversorgung der Zuführeinrichtung von einem entsprechend ausgestalteten Bestückautomaten. Hinsichtlich der Vorteile dieser Ausgestaltung wird auf die Ausführungen bezüglich des Anspruchs 2 verwiesen.

Für die vorteilhaften Ausgestaltungen der Zuführeinrichtung gemäß der Ansprüche 9, 10, 11 und 12 gelten analog die Ausführungen bezüglich der Ansprüche 3, 4, 5 und 6.

Das Bestücksystem gemäß Anspruch gemäß dem Anspruch 13 umfasst einen erfindungsgemäßen Bestückautomaten und eine an daran gekoppelte erfindungsgemäße Zuführeinrichtung. Dabei ist der erste Infrarot-Empfänger des Bestückautomaten mit dem zweiten Infrarot-Sender der Zuführeinrichtung optisch gekoppelt und der erste Infrarot-Sender des Bestückautomaten ist mit dem zweiten Infrarot-Empfänger optisch gekoppelt, sodass ein Datenaustausch zwischen den jeweiligen Steuereinrichtungen möglich ist. Bezüglich der sich daraus ergebenden Vorteile wird auf die Ausführungen zu den jeweiligen vorhergehenden Ansprüchen verwiesen.

Das Bestücksystem kann gemäß Anspruch 14 dahingehend ausgestaltet werden, dass der erste Infrarot-Empfänger bzw. der erste Infrarot-Sender auf Seiten des Bestückautomaten mit dem entsprechenden zweiten Infrarot-Sender bzw. zweiten Infrarot-Empfänger auf Seiten der Zuführeinrichtung jeweils über einen Lichtwellenleiter optisch gekoppelt sind. Bei dieser Ausgestaltung die Sender und Empfänger selbst nicht optisch sichtbar am Gehäuse der Zuführeinrichtung bzw. Bestückautomaten angebracht werden, sondern können gut geschützt im Inneren des Gehäuses der Zuführeinrichtung bzw. des Bestückautomaten vorgesehen sein. Die von den Infrarot-Sendern ausgesandten optischen Signale werden von den Lichtwellenleitern aus dem Inneren des Gehäuses des Bestückautomaten bzw. der Zuführeinrichtung an die Oberfläche geleitet, wo die Datenübertragung stattfindet. Entsprechend führen Lichtwellenleiter von den Oberflächen, an denen die Datenübertragung stattfindet, zu den im Gehäuse der Zuführeinrichtung bzw. des Bestückautomaten befindlichen Infrarot-Empfängern. Die Austrittspunkte der zu den Infrarot-Sendern führenden Lichtwellenleitern stehen in einem Zustand, in dem die Zuführeinrichtung mit dem Bestückautomaten gekoppelt ist, den Austrittspunkten der zu den Empfängern führenden Lichtwellenleitern durch einen geringen Luftspalt getrennt gegenüber oder berühren sich unmittelbar, so dass eine fehlerfreie Datenübertragung möglich ist.

Die in den Ansprüchen 15 und 16 beschriebenen Verfahren zur Datenübertragung beziehen sich auf die Datenübertragung zwischen einem Bestückautomaten und einer Zuführeinrichtung gemäß der Erfindung. Allgemein werden in einem ersten Schritt die von der sendenden Steuereinrichtung zu übertragenen Daten von dem der sendenden Steuereinrichtung zugeordneten CAN-Controller in entsprechende CAN-Protokoll konforme Daten umgewandelt. Nach einer weiteren Umwandlung der CAN-Protokoll konformen Daten in IrDA-Protokoll-konforme Daten durch den entsprechenden Protokoll-Wandlerbaustein werden diese IrDA-Protokoll-konformen Daten mittels eines Infrarot-Senders in entsprechende optische Signale umgewandelt. Ein mit dem Infrarot-Sender optisch gekoppelter Infrarot-Empfänger empfängt die optischen Signale und wandelt sie in entsprechende IrDA-Protokoll-konforme elektrische Daten um. Ein mit dem Empfänger elektrisch verbundener Protokoll-Wandlerbaustein wandelt dann diese IrDA-Protokoll-konformen Daten in CAN-Protokoll-konforme Daten um und leitet sie an den der empfangenden Steuereinrichtung zugeordneten CAN-Controller zu. Vom diesem CAN-Controller werden CAN-Protokoll-konformen Daten in entsprechende von der empfangenden Steuereinrichtung zu interpretierende Daten umgewandelt. Durch dieses Verfahren können die Vorteile der kontaktlosen optischen Datenübermittlung mit der Sicherheit und Schnelligkeit der Datenübertragung mittels CAN-Bus vereint werden.

Im Folgenden wird ein Ausführungsbeispiel der vorliegenden Erfindung anhand der beigefügten Figuren näher erläutert, wobei:
Figur 1 den prinzipiellen Aufbau eines CAN-Protokoll-konformen Standard-Datentelegramms,
Figur 2 eine Darstellung des Funktionsprinzips der optischen Datenübertragung gemäß der Erfindung,
Figur 3 ein mögliches Prinzip der Protokoll-Umwandlung von Daten zwischen dem CAN-Protokoll und dem IrDA-Protokoll,
Figur 4 ein Ausführungsbeispiel eines Bestücksystems mit einem Bestückungsautomaten und einer Zuführeinrichtungen gemäß der Erfindung,
Figur 5 eine schematische Darstellung eines Ausführungsbeispiels des erfindungsgemäßen Bestückungsautomaten bzw. Zuführeinrichtung mit induktiver Energieübertragung und optischer Datenübertragung,
Figur 6 eine perspektivische Ansicht eines Ausführungsbeispiels einer erfindungsgemäßen Zuführeinrichtung mit induktiver Energieübertragung und optischer Datenübertragung,
Figur 7 eine Querschnittsansicht eines Moduls zur induktiven Energieübertragung und optischen Datenübertragung,
Figur 8 eine schematische Frontansicht des in Fig. 7 dargestellten Moduls zur induktiven Energieübertragung und optischen Datenübertragung,
Figur 9 eine Seitenansicht eines vorteilhaftes Ausführungsbeispiel eines Magnetkerns zur induktiven Energieübertragung;
Figur 10 eine Querschnittansicht des in Fig.. 9 dargestellten Magnetkerns entlang der Schnittlinie A-A;
Figur 11 eine weitere Seitenansicht des in Fig. 9 dargestellten Magnetkerns, darstellen
In industriellen Fertigungssystemen werden zunehmend Feldbussysteme für die Kommunikation zwischen Subsystemen eingesetzt. Der Einsatz dieser Feldbussysteme bringt eine Reihe von Vorteilen, wie z. B. verminderter Verkabelungsaufwand, erhöhte Zuverlässigkeit, vereinfachte Tests des Gesamtsystems, größere Störsicherheit etc., mit sich. Ein Vertreter der Feldbussysteme, der so genannte CAN-Bus (CAN = Controller Area Network), weist sich durch eine hohe Zuverlässigkeit in der Datenübertragung aus. CAN-Busse entsprechen erhöhten Anforderungen an das Zeitverhalten. Ein deterministisches Zeitverhalten, d.h. die Vorhersagbarkeit der Zeit, die eine Nachricht maximal braucht, um zum Empfänger zu gelangen, ist eines der herausragenden Merkmale der CAN-Bus Technik. Die Datenübertragung mittels CAN-Bus ist sehr schnell und entspricht hohen Echtzeitanforderungen, bei denen zur Datenübertragung eine vorher definierte Zeit nicht überschritten werden darf.

Im CAN-Bus sind alle Teilnehmer gleichberechtigt, was bedeutet, dass jeder Teilnehmer eine Nachricht senden kann, sobald der Bus frei ist. Den Teilnehmern sind keine Adressen zugeordnet, sondern es wird zur Identifizierung von Nachrichten die Kennung der Teilnehmer (Identifier), an die die Nachricht gerichtet ist, mit gesendet. Um eine Kollision der übermittelten Nachrichten bei gleichzeitigem Aussenden mehrerer Teilnehmer zu verhindern, nutzt der CAN-Bus eine so genannte zerstörungsfreie Arbitrierung mittels des Identifiers. Durch dieses Zugriffsverfahren wird jeder Teilnehmer aufgrund des Identifiers priorisiert. Die Nachricht mit der höchsten Priorität wird nicht zerstört, sondern vollständig übertragen. Die niederprioren Teilnehmer senden nach Freiwerden des Busses ihre Nachrichten erneut ab.

Beim CAN-Bus wird jedem übertragenen Bit genau ein Zustand eines Logikpegels zugeordnet. Die möglichen Zustände sind "Low" (entspricht 0) und "High" (entspricht 1). Mehrere gleiche Bits hintereinander erscheinen auf dem Bus als ein entsprechend längerer, gleich bleibender Pegel. Die BusTeilnehmer synchronisieren die übertragenen Bits selbstständig. Grundsätzlich ist auf dem CAN-Bus der Low-Pegel dominant und der High-Pegel rezessiv.

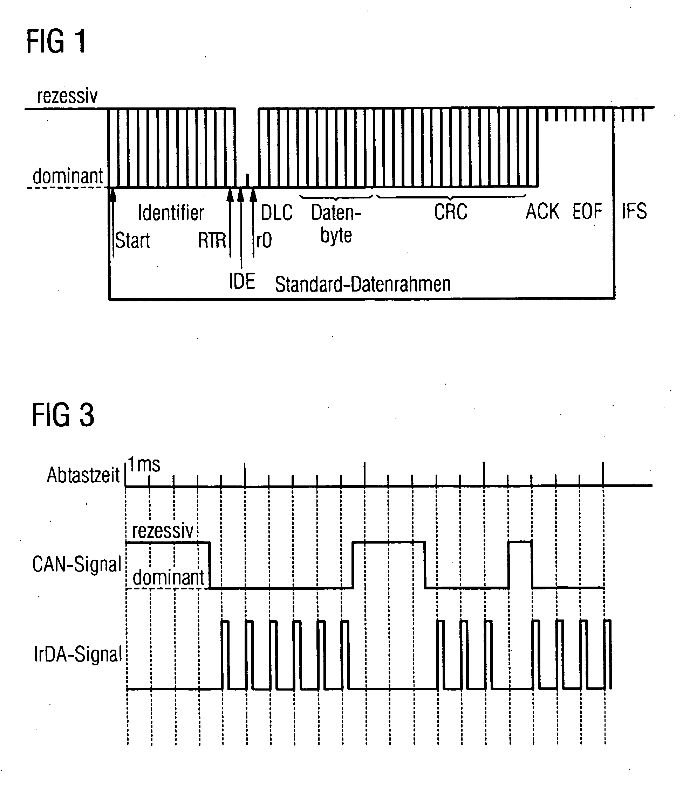

Die eigentlichen Nutzdaten werden beim CAN-Bus mit einem so genannten Datenrahmen umgeben, um die Nutzdaten auf einem Netz versenden zu können. Figur 1 stellt den prinzipiellen Aufbau eines solchen Standard-Datenrahmens dar. Wie oben erwähnt, entspricht jedes Datenbit entweder einem rezessiven oder dominanten Logikpegel. Das Startbit kennzeichnet den Anfang des übertragenen Telegramms. Der nachfolgende, elf Bits lange Identifier gibt die Priorität der Botschaft an. Nach den Bits RTR, IDE und r0, welche hier nicht weiter behandelt werden, folgt das DLC-Feld (Data Length Code), welches die Länge des nachfolgenden Nutzdatenfeldes in Bytes angibt. Anschließend kommt die Übertragung der eigentlichen Nutzdaten mit einem Umfang zwischen Null und 8 Byte. Nach dem CRC-Feld, welches zur Fehlererkennung verwendet wird, folgt das Acknowledge-Bit, auf welches jeder Busteilnehmer, der die Nachricht fehlerfrei erhalten hat, ein so genanntes Acknowledge-Bit an den Sender übermittelt. Auf die beiden Felder EOF und EFF wird hier nicht weiter eingegangen.

Der vorliegenden Erfindung liegt die Idee zugrunde, am Markt erhältliche, kostengünstige, digital ansteuerbare Bauelemente für die Infrarot-Kommunikation zur drahtlosen CAN-Bus-Übertragung einzusetzen. Zur Datenkommunikation mittels Infrarot-Technik wurde von der Infrared-Data-Association (IrDA) ein Standard entwickelt, der sich durch geringen Energieverbrauch, eine einfache, effiziente und zuverlässige Datenübertragung auszeichnet, die gegenüber äußeren Einflüssen wie z. B. Lichteinfall und Störungen wie z. B. Reflexionen, unempfindlich ist. Ein weiterer Vorteil der IrDA-Technologie ist die Darstellung extrem kurzer Lichtimpulse, was in Verbindung mit den strengen Echtzeitanforderungen des CAN-Busses unbedingt notwendig ist.

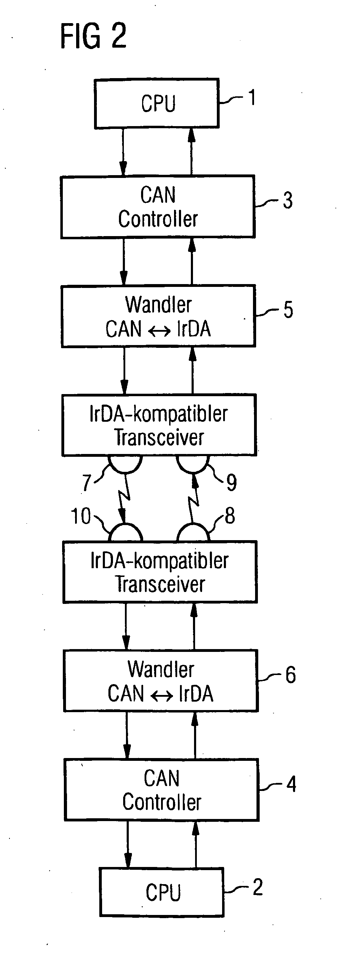

Figur 2 stellt schematisch das Funktionsprinzip zur Datenübertragung zwischen zwei Steuereinrichtungen dar. Einer ersten Steuereinrichtung (CPU) 1 bzw. zweiten Steuereinrichtung 2 ist ein erster CAN-Controller 3 bzw. zweiter CAN-Controller 4 zugeordnet. Der erste bzw. zweite CAN-Controller 3, 4 ist mit einem ersten bzw. zweiten Protokoll-Wandlerbaustein 5 bzw. 6 elektrisch verbunden. Der erste und zweite Protokoll-Wandlerbaustein 5 und 6 sind so ausgeführt, dass sie CAN-Protokoll-konforme Daten und IrDA-Protokoll-konforme Daten ineinander umwandeln können. Der erste bzw. zweite Protokoll-Wandlerbaustein 5 bzw. 6 sind jeweils mit einem ersten bzw. zweiten Infrarot-Sender 7 bzw. 8 und einem ersten bzw. zweiten IrDA-kompatiblen Infrarot-Empfänger 9 bzw. 10 elektrisch verbunden. Der erste Infrarot-Sender 7 und der erste Infrarot-Empfänger 9 bzw. der zweite Infrarot-Sender 8 und der zweite Infrarot-Empfänger 9 sind in Fig. 2 in einer Funktionseinheit (Transceiver) zusammengefasst. Die Infrarot-Sender 7, 8 haben die Aufgabe, elektrische Daten der Protokoll-Wandlerbausteine 5, 6 in entsprechende optische Signale umzuwandeln, wogegen der IrDA-kompatible Infrarot-Empfänger 9, 10 empfangene optische Signale in entsprechende elektrische Signale zurückwandelt. Die optischen Infrarot-Sender 7, 8 und die optischen Infrarot-Empfänger 9, 10 müssen dabei so angeordnet sein, dass sie optisch koppelbar sind. Im optisch gekoppelten Zustand können von den Infrarot-Sendern 7, 8 ausgesandte optische Signale vom den jeweiligen Infrarot-Empfängern 9, 10 empfangen werden.

Im Folgenden wird ein Verfahren zur Datenübertragung in der in Figur 1 beschriebenen Anordnung näher erläutert. Es wird dabei angenommen, dass die erste Steuereinrichtung 1 Daten an die zweite Steuereinrichtung 2 übermittelt, weshalb die erste Steuereinrichtung 1 nachfolgend als die zu sendende Steuereinrichtung (CPU) und die zweite Steuereinrichtung 2 als die zu empfangende Steuereinrichtung (CPU) bezeichnet wird.

In einem ersten Schritt werden die von der sendenden Steuereinrichtung zu übertragenden Daten von dem ersten CAN-Controller 3 in entsprechende CAN-Protokoll-konforme Daten umgewandelt. Die CAN-Protokoll-konformen Daten werden mittels des ersten Protokoll-Wandlerbausteins 5 in IrDA-Protokoll-konforme Daten umgewandelt. Auf dem Vorgang der Protokoll-Umwandlung wird weiter unten genauer eingegangen. Die IrDA-Protokoll-konformen elektrischen Daten werden an den ersten Infrarot-Sender 7 weiter geleitet, der die elektrischen Daten in entsprechende optische Signale umwandelt. Diese optischen Signale werden von dem zweiten Infrarot-Empfänger 10 empfangen und in entsprechende elektrische Signale zurückgewandelt. Diese immer noch IrDA-Protokoll-konformen elektrischen Daten werden durch den zweiten Protokoll-Wandlerbaustein 6 nun in CAN-Protokoll-konforme Daten umgewandelt und an den zweiten CAN-Controller 4 weiter geleitet. Der zweite CAN-Controller 4 konvertiert die CAN-Protokoll-konformen Daten in entsprechende, von der empfangenden Steuereinrichtung verarbeitbare Daten.

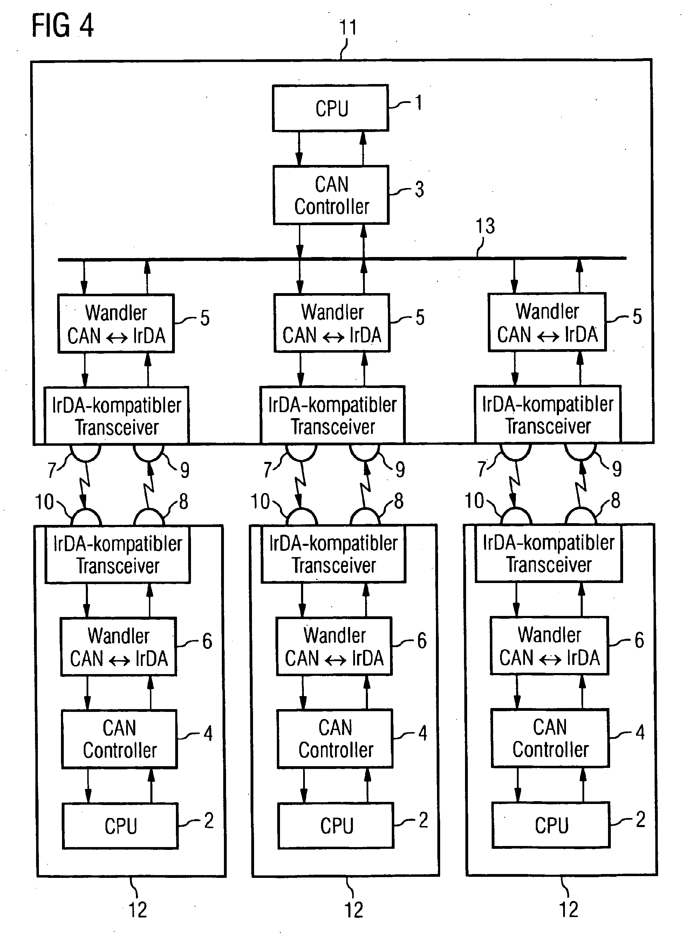

Anhand der Figur 3 wird eine mögliche Umwandlung von CAN-Protokoll-konformen Daten in IrDA-Protokoll-konforme Daten näher erläutert. Wie schon weiter oben erwähnt, werden Datenbits entsprechend des CAN-Protokolls entweder über einen rezessiven oder über einen dominanten Logikpegel dargestellt. Eine mögliche Umwandlung der CAN-Protokoll-konformen Daten in IrDA-Protokoll-konforme Daten durch einen der Protokoll-Wandlerbausteine (Bezugszeichen 5, 6 in Fig. 2) könnte, wie in Figur 3 dargestellt, so erfolgen, dass zu jedem Abtastzeitpunkt (in Figur 4 eine Millisekunde bei 1 MBaud Übertragungsrate) und nur dann, wenn ein dominanter Logikpegel am CAN-Bus anliegt, ein entsprechendes zeitlich sehr kurzes Signal vom Wandlerbaustein ausgegeben wird. Bei Anliegen eines rezessiven Logikpegels werden keine Signale ausgegeben. Diese sehr kurzen elektrischen Impulse werden dann von einem Infrarot-Sender (Bezugszeichen 7, 8 in Fig. 2) als entsprechende optische Signale ausgesendet und von den Infrarot-Empfängern (Bezugszeichen 9, 10 in Fig. 2) empfangen. Dies ist nur möglich, da die Infrarot-Technik eine sehr kurze Ansprechzeit aufweist und deshalb sehr kurze Lichtimpulse ausgesendet und empfangen werden können. Die IrDA-Protokoll-konformen Daten werden durch die Protokoll-Wandlerbausteine nach demselben Schema in CAN-Protokoll-konforme Daten zurückinterpretiert.

Figur 4 stellt ein Bestücksystem mit einem Bestückautomaten 11 und mehreren daran gekoppelten Zuführeinrichtungen 12 für elektrische Bauteile dar. An dem Bestückautomaten 11 zum Bestücken von Substraten mit elektrischen Bauelementen sind mehrere Zuführeinrichtungen 12 gekoppelt, die für die Zufuhr und die Bereitstellung der elektrischen Bauelemente an der Abholposition für einen Bestückkopf des Bestückautomaten 11 zuständig sind. Der Bestückautomat 11 ist mit einer zentralen ersten Steuereinrichtung (CPU) 1 ausgestattet. Die zentrale erste Steuereinrichtung 1 des Bestückautomaten 11 ist mit einem ersten CAN-Controller 3 des Bestückautomaten 11 verbunden, welcher Daten in einen dem Bestückautomaten 11 zuzuordnenden CAN-Bus 13 eingespeist oder von diesem empfängt. An dem Bestückautomaten 11 sind mehrere Koppelstellen für die Zuführeinrichtungen 12 vorgesehen. Jede Koppelstelle zeichnet sich durch einen ersten IrDA-kompatiblen Transceiver und einen ersten Protokoll-Wandlerbaustein 5, über welchen der erste Transceiver an den CAN-Bus 13 angekoppelt ist, aus. Die ersten IrDA-kompatiblen Transceiver bestehen jeweils aus einem ersten IrDA-kompatiblen Infrarot-Empfänger 9 und einem ersten Infrarot-Sender 7.

Jede der Zuführeinrichtungen 12 weist eine eigene zweite Steuereinrichtung (CPU) 2 auf, die während des Betriebs des Bestückautomaten 11 mit der zentralen ersten Steuereinrichtung 1 des Bestückautomaten 11 kommuniziert und Daten austauscht. Ferner verfügt jede Zuführeinrichtung 12 über einen mit der jeweiligen zweiten Steuereinrichtung 2 elektrisch verbundenen zweiten CAN-Controller 4, einen zweiten Protokoll-Wandlerbaustein 6 zur Protokollumwandlung zwischen CAN-Protokoll und IrDA-Protokoll, sowie einen zweiten IrDA-kompatiblen Transceiver. Der zweite IrDA-kompatible Transceiver besteht aus einem zweiten IrDA-kompatiblen Infrarot-Empfänger 10 und einem zweiten Infrarot-Sender 8.

Die ersten IrDA-kompatible Transceiver des Bestückautomaten 11 und die zweiten IrDA-kompatible Transceiver der Zuführeinrichtungen 12 sind dabei so angeordnet, dass sie in einem Zustand, in dem die Zuführeinrichtungen 12 an den Bestückautomaten 11 gekoppelt sind, optisch gekoppelt sind. Dies bedeutet, dass in diesem Zustand von den zweiten Infrarot-Sendern 8 auf Seiten der Zuführeinrichtungen 12 ausgesendete optische Signale von den entsprechenden ersten Infrarot-Empfängern 9 auf Seiten des Bestückautomaten 11 bzw. die von den ersten Infrarot-Sendern 7 auf Seiten des Bestückautomaten 11 ausgesendeten optischen Signale von den zweiten Infrarot-Empfängern 10 der entsprechenden Zuführeinrichtungen 12 empfangen werden können. In dem Moment, in dem die Zuführeinrichtungen 12 an den Bestückautomaten 11 angekoppelt sind, sind sie zusammen mit der zentralen ersten Steuereinrichtung 1 des Bestückautomaten 11 Teilnehmer am CAN-Bus 13. Durch die optische Datenübertragung entfällt hierbei eine elektrische Steckverbindung zur Herstellung einer Datenverbindungsleitung zwischen den Zuführeinrichtungen 12 und den Bestückautomaten 11. Dadurch wird nicht nur der Verkabelungsaufwand reduziert, sondern auch die Gefahr eines Ausreißens einer Steckverbindung ist nicht mehr gegeben, was die Betriebssicherheit deutlich erhöht.

Bei dem in Fig. 4 dargestellten Bestücksystem sind die Koppelstellen unmittelbar am Bestückautomaten 11 vorgesehen. Es wird jedoch darauf hingewiesen, dass sich der Erfindungsgedanke auch auf Ausgestaltungen erstreckt, bei denen die Koppelstellen (bestehend aus jeweils einem ersten IrDA-kompatiblen Transceiver und einem ersten Protokoll-Wandlerbaustein 5) nicht unmittelbar am Bestückautomaten 11 angeordnet sind. Beispielsweise können die Koppelstellen entsprechend an einer mobilen Trägereinrichtung für die Zuführeinrichtungen 12, beispielsweise einen Wagen, vorgesehen sein, welche zusammen mit den Zuführeinrichtungen an den Bestückautomaten herangefahren und mit diesem über eine einzige Kabelverbindung (Buskabel), welche die Datenübertragung zwischen dem Bestückautomaten und den Zuführeinrichtungen gewährleistet, gekoppelt wird. Auch in diesem Fall entfällt die Notwendigkeit, die Zuführeinrichtungen jeweils über ein Kabel mit dem Bestückautomaten zu verbinden, weshalb sich gleiche Vorteile ergeben.

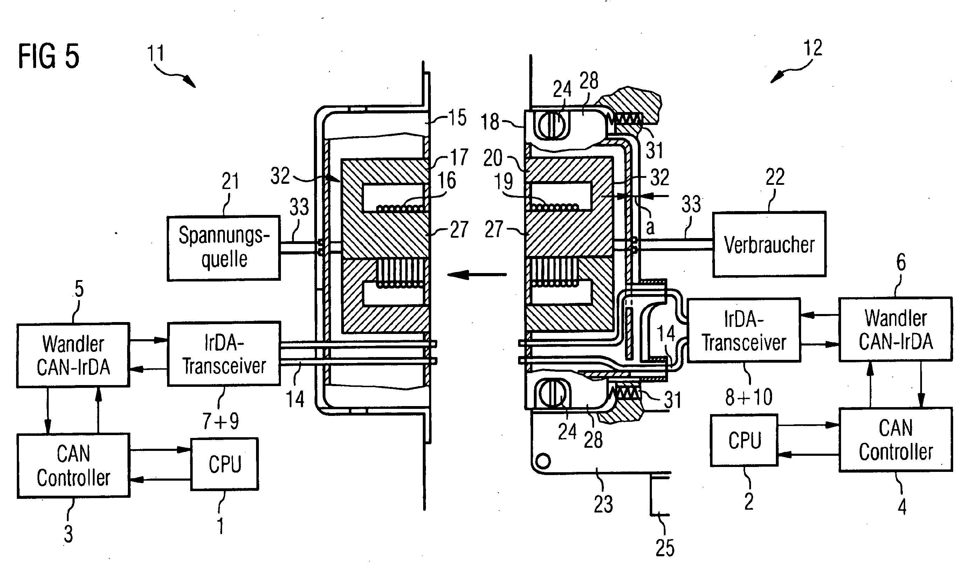

In Fig. 5 ist eine vorteilhafte Ausgestaltung des erfindungsgemäßen Bestückautomaten 11 und der erfindungsgemäßen Zuführeinrichtung 12 dargestellt. In diesem Ausführungsbeispiel umfassen der Bestückautomat 11 und die Zuführeinrichtung 12 neben der erfindungsgemäßen Vorrichtung zur berührungslosen Datenübertragung auch noch eine Einrichtung zur induktiven Energieübertragung.

Der Bestückautomat 11 (in Fig. 5 links dargestellt) und die Zuführeinrichtung 12 (in Fig. 5 rechts dargestellt) weisen jeweils die zur berührungslosen Datenübertragung notwendigen Elemente (CPU, CAN-Controller, Protokoll-Wandlerbaustein, Ir-DA-Transceiver) gemäß der anhand der Figs. 2 und 4 erläuterten Vorrichtung auf. Die optische Datenübertragung wird deshalb hier nicht mehr näher erläutert, sondern es wird auf die Ausführungen zu den Figuren 2 und 4 verwiesen. Zu bemerken ist jedoch, dass sich die IrDA-Transceiver (bestehend aus Infrarot-Sender 7,8 und Infrarot-Empfänger 9, 10) gut geschützt im Gehäuse der Zuführeinrichtung 12 bzw. im Gehäuse des Bestückautomaten 11 befinden. Von den Infrarot-Sendern 7, 8 und den Infrarot-Empfängern 9, 10 der Transceiver führen jeweils Lichtwellenleiter 14 and die gegenüberliegenden Oberflächen der Gehäuse des Bestückautomats 11 und Zuführeinrichtung 12. Dies hat zur Folge, dass in einem Zustand, in dem die Zuführeinrichtung 12 an den Bestückautomaten 11 gekoppelt ist, sich die Kontaktflächen der zu den Infrarot-Sendern 7, 8 führenden Lichtwellenleiter 14 und die Kontaktflächen der zu den entsprechend gegenüberliegenden Infrarot-Empfängern 9, 10 führenden Lichtwellenleiter 14 idealerweise direkt berühren oder sich durch einen geringen Luftspalt getrennt gegenüberstehen. So wird im gekoppelten Zustand eine Übertragung der optischen Signale sichergestellt. Genauso wäre es jedoch denkbar, die Infrarot-Sender 7, 8 und Infrarot-Empfänger 9, 10 entsprechend direkt an der Oberfläche der Gehäuse vorzusehen, sodass eine direkte Übertragung optischer Signal ohne Lichtwellenleiter 14 möglich ist.

Im Folgenden wird nun die Einrichtung zur induktiven Energieübertragung erläutert. Auf Seiten des Bestückautomaten 11 ist in einem ersten Gehäuse 15 ein mit einer Primärspule 16 umwickelter erster Magnetkern 17 vorgesehen. Das erste Gehäuse 15 ist zusammen mit dem ersten Magnetkern 17 fest mit dem Bestückautomaten 11 verbunden. An einer dem Bestückautomaten 11 zugewandten Stirnseite der Zuführeinrichtung 12 ist in einem zweiten Gehäuse 18 ein mit einer Sekundärspule 19 umwickelter zweiter Magnetkern 20 vorgesehen. Beide Magnetkerne 17, 20 sind aus einem Material mit hoher magnetischer Permeabilität (d.h. hoher Durchlässigkeit für magnetische Felder), beispielsweise aus Ferrit, gefertigt, um eine möglichst starke Bündelung des Magnetfelds und damit eine gute Energieübertragung zu gewährleisten. Wie der Fig. 5 zu entnehmen ist, sind der erste Magnetkern 17 mit der Primärspule 16 auf Seiten des Bestückautomaten 11 und der zweite Magnetkern 20 mit der Sekundärspule 19 auf Seiten der Zuführeinrichtung 12 identisch ausgeführt. Die Primärspule 16 des ersten Magnetkerns 17 ist mit einer dem Bestückautomaten 11 zugeordneten Spannungsquelle 21 elektrisch verbunden, wogegen die Sekundärspule 19 des zweiten Magnetkerns 20 mit einem oder mehreren Verbrauchern 22 (beispielsweise Antriebsmotoren) auf Seiten der Zuführeinrichtung 12 elektrisch verbunden ist. Durch Aneinanderbringen der beiden Magnetkerne 17, 20 kommt es zu einer induktiven Energieübertragung von der Spannungsquelle 21 zu den Verbrauchern 22.

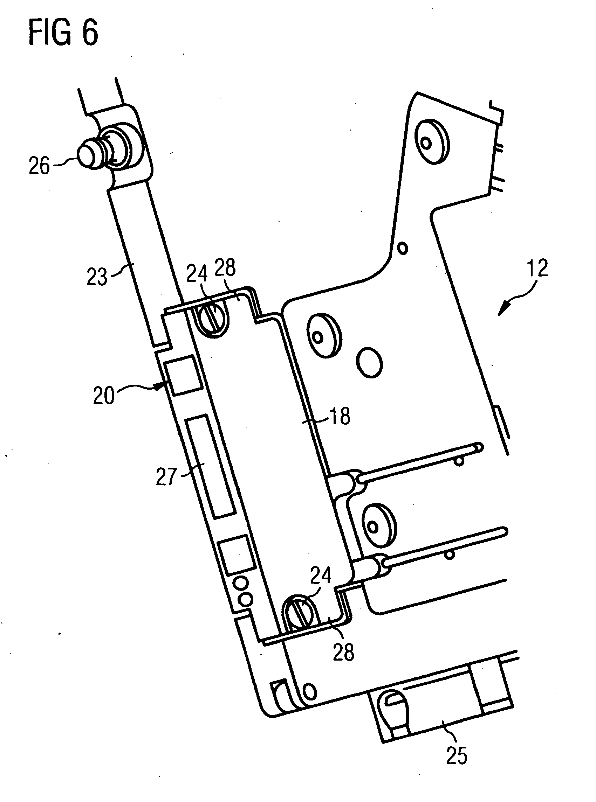

In Figur 6 ist ein vorteilhaftes Ausführungsbeispiel einer Zuführeinrichtung 12 teilweise perspektivisch dargestellt. Die Zuführeinrichtung 12 weist ein Zuführeinrichtungsgehäuse 23 auf, in dem die gesamte Elektronik und Mechanik der Zuführeinrichtung 12, wie beispielsweise elektrische Vorschubmotoren, untergebracht sind. Das zweite Gehäuse 18 des zweiten Magnetkerns 20 ist mittels zweier Schrauben 24 an der Vorderseite des Gehäuses der Zuführeinrichtung 12 angebracht. Kontaktflächen des sich in dem zweiten Gehäuse 18 befindlichen zweiten Magnetkerns 20 sind auf der dem Bestückautomaten 11 zugewandten Seite des zweiten Gehäuses 18 offen gelegt und schließen bündig mit dem zweiten Gehäuse 18 ab. An der Unterseite des Zuführeinrichtungsgehäuses 23 sind Führungselemente 25 vorgesehen. Zum Anbringen der Zuführeinrichtung 12 am Bestückautomaten 11, wird die Zuführeinrichtung 12 mit den Führungselementen auf entsprechende Führungsschienen (nicht dargestellt) am Bestückautomaten 11 aufgesetzt und entlang der Führungsschienen in einer Verschieberichtung (in Fig. 5 durch einen Pfeil gekennzeichnet) bis zum Anschlag an den Bestückautomaten 11 herangefahren (gekoppelter Zustand). An der Vorderseite der Zuführeinrichtung 12 ist ein Justierbolzen 26 vorgesehen, der beim Anbringen der Zuführeinrichtung 12 in eine entsprechende Aufnahmeöffnung auf Seiten des Bestückautomaten 11 einrastet. Der Justierbolzen 26 dient der Stabilisierung der Zuführeinrichtung 12 und fixiert diese in ihrer vorgesehenen Lage.

Bei der in Fig. 5 dargestellten Ausgestaltung sind die zur optischen Datenübertragung (erster Transceiver und erster Wandlerbaustein) und die zur induktiven Energieübertragung (mit Primärspule umwickelter erster Magnetkern) benötigten Bauteile unmittelbar am Bestückautomaten 11 vorgesehen. Es wird jedoch darauf hingewiesen, dass sich der Erfindungsgedanke auch auf Ausgestaltungen erstreckt, bei denen diese Bauteile nicht unmittelbar am Bestückautomaten 11 angeordnet sind. Beispielsweise können diese Bauteile entsprechend an einer mobilen Trägereinrichtung für die Zuführeinrichtungen 12, beispielsweise einem Wagen, vorgesehen sein, welche zusammen mit den Zuführeinrichtungen an den Bestückautomaten herangefahren und mit diesem über eine einzige Kabelverbindung (Buskabel und Stromkabel), welche die Energie- und die Datenübertragung zwischen dem Bestückautomaten und den Zuführeinrichtungen gewährleistet, gekoppelt wird.

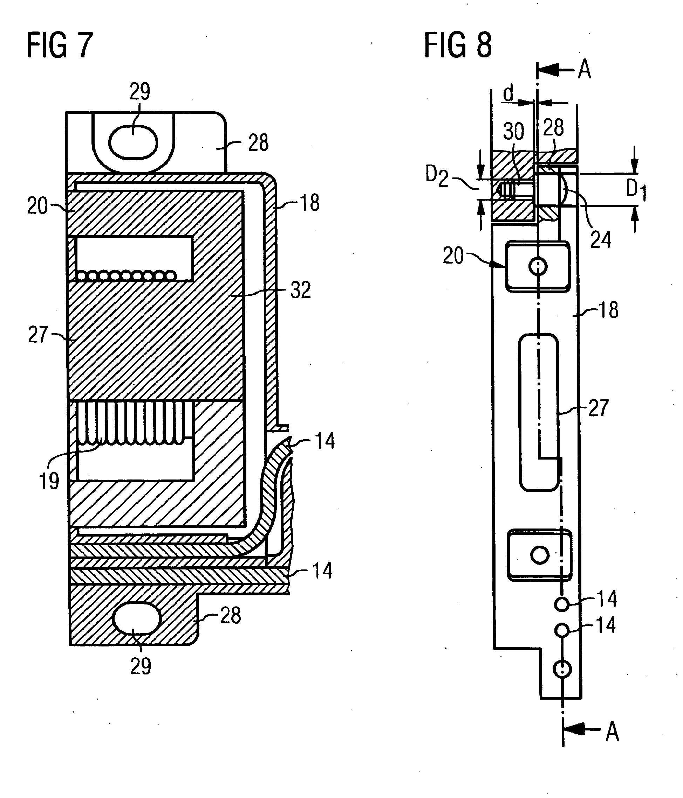

Anhand der Figuren 7 und 8 wird ein vorteilhafter Aufbau des in Fig. 5 gezeigten zweiten Gehäuses 18 mit dem darin untergebrachten zweiten Magnetkern 20 näher erläutert. Figur 7 stellt dabei eine Querschnittansicht entlang der Linie A-A in Fig. 8 dar. Der dargestellte zweite Magnetkern 20 weist die Form des lateinischen Buchstabens "E" auf, dessen mittlerer Schenkel 27 mit der Sekundärspule 19 umwickelt ist. Das zweite Gehäuse 18 des zweiten Magnetkerns 20 weist an der Ober- und Unterseite jeweils eine flanschartige Erweiterung 28 auf, die ein in Verschieberichtung der Zuführeinrichtung 12 gerichtetes Langloch 29 aufweist. Die Leichtwellenleiter 14 der Vorrichtung zur optischen Datenübertragung verlaufen durch das Gehäuse des zweiten Magnetkerns 20 und münden mit ihren Kontaktflächen außerhalb des Gehäuses. Aus der in Figur 8 dargestellten Vorderansicht des zweiten Gehäuses 18 des zweiten Magnetkerns 20 wird deutlich, wie das zweite Gehäuse 18 mittels Schrauben 24 an dem Zuführeinrichtungsgehäuse 23 befestigt wird. Am Zuführeinrichtungsgehäuse 23 sind Gewindebohrungen so vorgesehen, dass das zweite Gehäuse 18 des zweiten Magnetkerns 20 mittels der durch die Langlöcher 29 geführten Schrauben 24 am Zuführeinrichtungsgehäuse 23 befestigt werden kann. Der vertikale Durchmesser (D1) der Langlöcher 29 ist dabei größer ausgeführt als der Gewindedurchmesser (D2) der Gewindebohrungen 30. Die zur Befestigung des zweiten Gehäuses 18 verwendeten Schrauben 24 weisen in einem vorderen Abschnitt ein zur Gewindebohrung 30 passendes Gewinde auf, wobei sich der Durchmesser des Schraubenschafts in der Nähe des Schraubenkopfes stufenartig erweitert, so dass sich die Schrauben 24 nur bis zu einem bestimmten Grad in die Bohrung einschrauben lassen. Der Schraubenteil mit erweitertem Durchmesser ist z. B. um einige Zehntel Millimeter länger ausgeführt als die Breite der flanschartigen Erweiterung des zweiten Gehäuses 18 des zweiten Magnetkerns 20. Dadurch wird verhindert, dass das zweite Gehäuse 18 des zweiten Magnetkerns 20 vollkommen fest an dem Gehäuse der Zuführeinrichtung 12 angeschraubt wird. Mit anderen Worten, existiert zwischen dem Gehäuse der Zuführeinrichtung 12 und dem zweiten Gehäuse 18 des zweiten Magnetkerns 20 im angeschraubten Zustand ein gewisses Spiel (d). Das zweite Gehäuse 18 ist somit horizontal in der Verschieberichtung der Zuführeinrichtung 12 beweglich gelagert, wobei die Langlöcher 29 und die erweiterten Teile der Schraubenschäfte als Führungen dienen.

Aus Figur 8 geht ferner hervor, dass das zweite Gehäuse 18 zusammen mit dem darin enthaltenen zweiten Magnetkern 20 inklusive der Sekundärspule 19 die Breite des Zuführeinrichtungsgehäuses 23 nicht überschreitet. Durch die sehr schlanke Ausbildung des zweiten Magnetkerns 20 und seines zweiten Gehäuses 18 kann eine hohe Anzahl an Zuführeinrichtungen 12 in einem engen Rastermaß entlang dem Bestückautomaten 11 vorgesehen werden.

Wie in Figur 5 erkennbar ist, ist das zweite Gehäuse 18 des zweiten Magnetkerns 20 im montierten Zustand an seiner Rückseite über zwei Schraubenfedern 31 gegenüber dem Zuführeinrichtungsgehäuse 23 federnd gelagert. Die Schraubenfedern 31 werden vor der Montage des zweiten Gehäuses 18 des zweiten Magnetkerns 20 in entsprechende Bohrungen auf Seiten des Zuführeinrichtungsgehäuses 23 eingesetzt. Durch die Federkraft wird das beweglich gelagerte zweite Gehäuse 18 des zweiten Magnetkerns 20 im ungekoppelten Zustand (d.h. in einem Zustand, in dem die Zuführeinrichtung 12 noch nicht vollständig am Bestückautomaten 11 angebracht ist) in Verschieberichtung nach vorne gedrückt, so dass es an der Vorderseite der Zuführeinrichtung 12 etwas übersteht. An Stelle der Schraubenfedern 31 können auch elastomerische Elemente, wie etwa Gummipfropfen vorgesehen werden. Wird die Zuführeinrichtung 12 nun entlang der Schienen des Bestückautomaten 11 bis zum Anschlag an den Bestückautomaten 11 geschoben, so wird das zweite Gehäuse 18 an das erste Gehäuse 15 des ersten Magnetkerns 17 gedrückt. Dadurch werden die an den Vorderseiten der Gehäuse 15, 18 der beiden Magnetkerne 17, 20 freiliegenden Kontaktflächen der Magnetkerne 17, 20 in Kontakt gebracht (gekoppelter Zustand). Da, wie oben erwähnt, das zweite Gehäuse 18 des zweiten Magnetkerns 20 im ungekoppelten Zustand geringfügig über die Vorderseite der Zuführeinrichtung 12 hinausragt, wird das zweite Gehäuse 18 beim Ankoppeln entgegen der Verschieberichtung der Zuführeinrichtung 12 bewegt, wodurch die beiden Schraubenfedern 31 zumindest teilweise zusammengedrückt werden. Die dadurch entstehende Andrückkraft drückt die Kontaktflächen des zweiten Magnetkerns 20 gegen die Kontaktflächen des ersten Magnetkerns 17. Auf diese Weise wird sichergestellt, dass zwischen den Kontaktflächen der beiden Magnetkerne kein Spalt entsteht, wodurch eine hohe Effizienz der induktiven Energieübertragung erreicht wird.

Weiterhin wird aus Figur 5 deutlich, dass zwischen der Oberseite, der Unterseite und der Rückseite des zweiten Gehäuses 18 und dem Gehäuse der Zuführeinrichtung 12 ein gewisser Abstand (a) (typischerweise ein Millimeter) existiert. Dadurch ist das zweite Gehäuse 18 des zweiten Magnetkerns 20 gegenüber dem Zuführeinrichtungsgehäuse 23 nicht nur in der Verschieberichtung des Zuführeinrichtungsgehäuses 23 verschiebbar, sondern auch um eine zu den Schraubenschäften parallele Drehachse drehbar bzw. kippbar gelagert. Sollte sich also die relative Winkellage des ersten Gehäuses 15 des ersten Magnetkerns 17 auf Seiten des Bestückautomaten 11 zum Beispiel durch Wärmeverzug ändern, so kann sich das zweite Gehäuse 18 des zweiten Magnetkerns 20 auf Seiten der Zuführeinrichtung 12 im gekoppeltem bzw. angedrücktem Zustand durch leichtes Drehen bzw. Kippen an die geänderte Lage des ersten Gehäuses 15 des ersten Magnetkerns 17 anpassen. Somit wird gewährleistet, dass auch bei einer leicht veränderten Winkellage des ersten Gehäuses 15 die Kontaktflächen der ersten und zweiten Magnetkern 17, 20 im angedrückten Zustand immer vollständig aneinander anliegen. Somit wird verhindert, dass zwischen den Kontaktflächen ein Luftspalt auftritt, wodurch eine höhere Effizienz der Energieübertragung erreicht wird.

In den Figuren 5 und 7 ist erkennbar, dass das zweite Gehäuse 18 an der zur Zuführeinrichtung 12 zugewandten Rückseite Aussparungen besitzt, durch die die Lichtwellenleiter 14 der Vorrichtung zur optischen Datenübertragung durchgeführt werden können. Da in dieser Ausführung auch die Lichtwellenleiter 14 durch das zweite Gehäuse 18 des zweiten Magnetkerns 20 verlaufen, ergeben sich die oben erwähnten Vorteile auch für die Kontaktierung der Lichtwellenleiter 14 der Zuführeinrichtung 12 mit den Lichtwellenleiter 14 des Bestückautomaten 11.

Wie anfangs schon erwähnt wurde, sind in diesem Ausführungsbeispiel der mit der Primärspule 16 umwickelte erste Magnetkern 17 und der mit der Sekundärspule 19 umwickelte zweite Magnetkern 20 identisch ausgebildet. Das erste Gehäuse 15 des ersten Magnetkerns 17 unterscheidet sich vom zweiten Gehäuse 18 des zweiten Magnetkerns 20 nur dadurch, dass es über keine Langlöcher 29 verfügt und dass es fest und ungefedert am Bestückautomaten 11 angebracht ist. Gleichzeitig ist das erste Gehäuse 15 zusammen mit dem darin untergebrachten ersten Magnetkern 17 und der Primärspule 16 so schmal ausgeführt, dass es die Breite des Zuführeinrichtungsgehäuses 23 nicht überschreitet. Dies gewährleistet, dass wenn eine Vielzahl von Zuführeinrichtungen 12 in einem engen Rastermaß an der Bestückeinrichtung angebracht wird, jedem der zweiten Magnetkern 20e auf Seiten der Zuführeinrichtung 12 ein entsprechender erster Magnetkern 17 auf Seiten des Bestückautomaten 11 gegenüber steht.

Auch wenn in diesem Ausführungsbeispiel nur der zweite Magnetkern 20 auf Seiten der Zuführeinrichtung 12 drehbar und federnd gegenüber dem Zuführeinrichtungsgehäuse 23 gelagert ist und der erste Magnetkern 17 auf Seiten des Bestückautomaten 11 fest und unbeweglich befestigt ist, so sind auch Konstruktionen denkbar und vorteilhaft, bei der entweder das erste Gehäuse 15 des ersten Magnetkerns 17 federnd und drehbar gegenüber dem Bestückautomaten 11 gelagert ist und das zweite Gehäuse 18 des zweiten Magnetkerns 20 fest an der Zuführeinrichtung 12 fixiert ist, oder aber eine Konstruktion, bei der die Gehäuse sowohl des ersten als auch des zweiten Magnetkerns 20 federnd und drehbar gelagert sind.

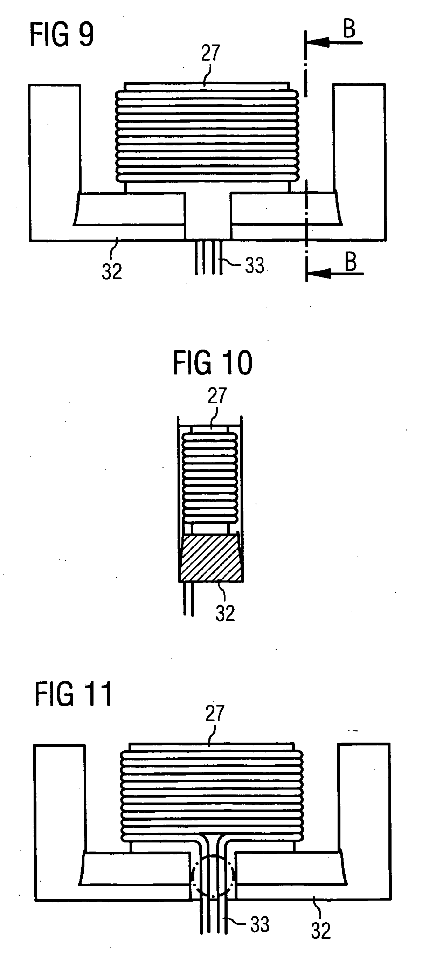

Eine vorteilhafte Ausgestaltung eines ersten oder zweiten Magnetkerns 17, 20 ist in den Figuren 9 bis 11 dargestellt und wird im Folgenden näher beschrieben.

Figur 9 zeigt eine Seitenansicht einer vorteilhaften Ausführungsform eines Magnetkerns. Der Magnetkern weist die Form des lateinischen Buchstaben "E" auf, wobei drei zueinander parallele Schenkel an jeweils einem ihrer Enden über ein Rückenteil 32 miteinander verbunden werden. Der mittlere der drei Schenkel ist mit einer Spule (welche eine Primär- oder eine Sekundärspule 19 sein kann) umwickelt. Die Spule weist elektrische Anschlussleitungen 33 auf, mit der sie entweder mit einer Spannungsquelle 21 oder mit einem Verbraucher 22 elektrisch verbunden werden kann. Je nach dem, ob die Spule mit einer Spannungsquelle 21 oder mit einem Verbraucher 22 elektrisch verbunden ist, spricht man von Primär- oder Sekundärspule 19.

Figur 10 stellt eine Querschnittsansicht des Magnetkerns entlang der Querschnittslinie B-B in Figur 9 dar. Der mit der Spule umwickelte mittlere Schenkel 27 des E-förmigen Magnetkerns ist so schmal ausgebildet, dass er zusammen mit der darauf aufgewickelten Spule die Breite des restlichen Magnetkerns nicht überschreitet.

Figur 11 zeigt eine andere Seitenansicht des Magnetkerns. Daraus geht hervor, dass das die drei Schenkel des Magnetkerns verbindende Rückenteil 32 im Bereich des mittleren Schenkels 27 so schmal ausgeführt, dass es an dieser Stelle bündig mit dem mittleren Schenkel 27 abschließt. In dieser Vertiefung des Rückenteils 32, können die Anschlussleitungen 33 der Spule versenkt geführt werden, so dass die Anschlussleitungen 33 seitlich nicht über den Magnetkern hinausragen. Dies wird auch noch in der Querschnittsansicht der Figur 10 deutlich, bei der zu sehen ist, dass die Anschlussleitungen 33 der Spule soweit in der Vertiefung des Rückenteils 32 versenkt geführt sind, so dass diese nicht über die Breite des E-Kerns hinausragen. Dadurch wird einerseits gewährleistet, dass die Anschlussleitungen 33 nicht eingeklemmt und beschädigt werden, andererseits kann der Magnetkern zusammen mit der Spule sehr schmal und kompakt ausgeführt werden.

In dem oben beschriebenen Ausführungsbeispiel sind der Bestückautomat und die Zuführeinrichtungen derart ausgebildet, dass eine optischen Datenübertragung und eine induktive Energieübertragung möglich sind. Bei diesem Ausführungsbeispiel sind weder zur Energieübertragung noch zur Datenübertragung zwischen dem Bestückautomaten und den Zuführeinrichtungen elektrische Steckverbindungen nötig. Dadurch wird einerseits der Verkabelungsaufwand beim Ankoppeln und Entfernen der Zuführeinrichtungen erheblich verringert und andererseits die Gefahr eines Defekts durch versehentlich ausgerissene Steckerverbindungen gebannt. Der Bestückautomat und die Zuführeinrichtungen zeichnen sich daher durch eine hohe Bedienerfreundlichkeit und eine hohe Betriebssicherheit aus.

### Bezugszeichenliste:

- 1: Erste Steuereinrichtung
- 2: Zweite Steuereinrichtung
- 3: Erster CAN-Controller
- 4: Zweiter CAN-Controller
- 5: Erster Protokoll-Wandlerbaustein
- 6: Zweiter Protokoll-Wandlerbaustein
- 7: Erster Infrarot-Sender
- 8: Zweiter Infrarot-Sender
- 9: Erster Infrarot-Empfänger
- 10: Zweiter Infrarot-Empfänger
- 11: Bestückautomat
- 12: Zuführeinrichtung
- 13: CAN-Bus
- 14: Lichtwellenleiter
- 15: Erstes Gehäuse des ersten Magnetkerns
- 16: Primärspule
- 17: Erster Magnetkern
- 18: Zweites Gehäuse des zweiten Magnetkerns
- 19: Sekundärspule
- 20: Zweiter Magnetkern
- 21: Spannungsquelle
- 22: Verbraucher
- 23: Zuführeinrichtungsgehäuse
- 24: Schraube
- 25: Führungselement
- 26: Justierbolzen
- 27: Mittlerer Schenkel
- 28: Flanschartige Erweiterung
- 29: Langloch
- 30: Gewindebohrung
- 31: Schraubenfeder
- 32: Rückenteil
- 33: Anschlussleitung

## Patentansprüche

1. Bestückautomat (11) zum Bestücken von Substraten mit elektrischen Bauelementen, mit
- einer ersten Steuereinrichtung (1), der ein erster CAN-Controller (3) zugeordnet ist,
- einem ersten Protokoll-Wandlerbaustein (5), der mit dem ersten CAN-Controller (3) elektrisch verbunden ist, um IrDA-Protokoll konforme Daten in CAN-Protokoll konforme Daten und CAN-Protokoll konforme Daten in IrDA-Protokoll konforme Daten umzuwandeln;
- einem ersten Infrarot-Sender (7) und einem ersten Ir-DA-kompatiblen Infrarot-Empfänger (9), die beide mit dem ersten Protokoll-Wandlerbaustein (5) elektrisch gekoppelt sind;
- wobei der erste Infrarot-Sender (7) mit einem zweiten Infrarot-Empfänger (10), der einer Zuführeinrichtung (12) für elektrische Bauteile zugeordnet ist, optisch koppelbar ist, und der erste Infrarot-Empfänger (9) mit einem zweiten Infrarot-Sender (8), der der Zuführeinrichtung (12) zugeordnet ist, optisch koppelbar ist.

2. Bestückautomat (11) gemäß Anspruch 1, ferner **gekennzeichnet durch**
- einen ersten Magnetkern (17), der mit einer Primärspule (16), die mit einer dem Bestückautomaten (11) zugeordneten Spannungsquelle (21) elektrisch verbunden ist, umwickelt ist,
- wobei der erste Magnetkern (17) so angeordnet ist, dass er mit einem der Zuführeinrichtung (12) zugeordneten zweiten Magnetkern (20), der mit einer Sekundärspule (19) umwickelt ist, koppelbar ist, und der erste Magnetkern (17) gegenüber dem Bestückautomaten (11) federnd gelagert ist, sodass der erste Magnetkern (17) im gekoppelten Zustand gegen den zweiten Magnetkern (20) gedrückt wird.

3. Bestückautomat (11) nach Anspruch 2, **dadurch gekennzeichnet, dass** der erste Magnetkern (17) zusätzlich drehbar gelagert ist, sodass einander zugewandte Kontaktflächen der ersten und zweiten Magnetkerne (17, 20) im angedrückten Zustand parallel aneinander liegen.

4. Bestückautomat (11) nach einem der Ansprüche 2 bis 3, **dadurch gekennzeichnet, dass** der erste Magnetkern (17) so schmal ausgeführt ist, dass er die Breite der Zuführeinrichtung (12) nicht überschreitet, und dass er in Bereichen, wo er mit der Primärspule (16) umwickelt ist, zusammen mit der Primärspule (16) die Breite der Zuführeinrichtung (12) nicht überschreitet.

5. Bestückautomat (11) nach Anspruch 4, **dadurch gekennzeichnet, dass** der erste Magnetkern (17) eine E-förmige Gestalt aufweist, dessen mittlerer Schenkel (27) von der Primärspule (16) umwickelt ist.

6. Bestückautomat (11) nach Anspruch 5, **dadurch gekennzeichnet, dass** das die drei Schenkel verbindende Rückenteil (32) des ersten Magnetkerns (17) zumindest im Bereich der Verlängerung des mittleren Schenkels (27) so schmal ausgebildet ist, dass es zumindest auf einer Seite des ersten Magnetkerns (17) bündig mit dem mittleren Schenkel (27) abschließt, um dort Anschlussleitungen (33) der Primärspule (16) zu führen.

7. Zuführeinrichtung (12) für elektrische Bauelemente, mit
- einer zweiten Steuereinrichtung (2), der ein zweiter CAN-Controller (4) zugeordnet ist,
- einem zweiten Protokoll-Wandlerbaustein (6), der mit dem zweiten CAN-Controller elektrisch verbunden ist, um zweite IrDA-Protokoll konforme Daten in CAN-Protokoll konforme Daten und CAN-Protokoll konforme Daten in IrDA-Protokoll konforme Daten umzuwandeln;
- einem zweiten Infrarot-Sender (8) und einem zweiten IrDA-kompatiblen Infrarot-Empfänger (10), die beide mit dem zweiten Protokoll-Wandlerbaustein (6) elektrisch gekoppelt sind;
- wobei der zweite Infrarot-Sender (8) mit einem ersten Infrarot-Empfänger (9), der einem Bestückautomaten (11) zugeordnet ist, optisch koppelbar ist, und der zweite Infrarot-Empfänger (10) mit einem ersten Infrarot-Sender (7), der dem Bestückautomaten (11) zugeordnet ist, optisch koppelbar ist.

8. Zuführeinrichtung (12) nach Anspruch 7, ferner **gekennzeichnet durch**
- ein Zuführeinrichtungsgehäuse (23),
- einen zweiten Magnetkern (20), der mit einer Sekundärspule (19), die mit einem der Zuführeinrichtung (12) zugeordneten elektrischen Verbraucher (22) elektrisch verbunden ist, umwickelt ist,
- wobei der zweite Magnetkern (20) so angeordnet ist, dass er mit einem einem Bestückautomaten (11) zugeordneten ersten Magnetkern (17), der mit einer Primärspule (16) umwickelt ist, koppelbar ist und der zweite Magnetkern (20) gegenüber dem Zuführeinrichtungsgehäuse (23) federnd gelagert ist, sodass der zweite Magnetkern (20) im gekoppelten Zustand gegen den ersten Magnetkern (17) gedrückt wird.

9. Zuführeinrichtung (12) nach einem der Ansprüche 7 bis 8, **dadurch gekennzeichnet, dass** der zweite Magnetkern (20) zusätzlich drehbar gelagert ist, sodass einander zugewandte Kontaktflächen der ersten und zweiten Magnetkerne (17), (20) im angedrückten Zustand parallel aneinander liegen.

10. Zuführeinrichtung (12) nach einem der Ansprüche 7 bis 9, **dadurch gekennzeichnet, dass** der zweite Magnetkern (20) so schmal ausgeführt ist, dass er die Breite des Zuführeinrichtungsgehäuses (23) nicht überschreitet, und dass er in Bereichen, wo er mit der Sekundärspule (19) umwickelt ist, zusammen mit der Sekundärspule (19) die Breite des Zuführeinrichtungsgehäuses (23) nicht überschreitet.

11. Zuführeinrichtung (12) nach Anspruch 10, **dadurch gekennzeichnet, dass** der zweite Magnetkern (20) eine E-förmige Gestalt aufweist, dessen mittlerer Schenkel (27) von der Sekundärspule (19) umwickelt ist.

12. Zuführeinrichtung (12) nach Anspruch 11, **dadurch gekennzeichnet, dass** das die drei Schenkel verbindende Rückenteil (32) des zweiten Magnetkerns (20) zumindest im Bereich der Verlängerung des mittleren Schenkels (27) so schmal ausgebildet ist, dass es zumindest auf einer Seite des zweiten Magnetkerns (20) bündig mit dem mittleren Schenkel (27) abschließt, um dort Anschlussleitungen (33) der Sekundärspule (19) zu führen.

13. Bestücksystem mit einem Bestückautomaten (11) nach einem der Ansprüche 1 bis 6 und mindestens einer an den Bestückautomaten (11) gekoppelten Zuführeinrichtung (12) nach einem der Ansprüche 7 bis 12, wobei der erste Infrarot-Sender (7) mit dem zweiten Infrarot-Empfänger (10) optisch gekoppelt ist und der erste Infrarot-Empfänger (9) mit dem zweiten Infrarot-Sender (8) optisch gekoppelt ist.

14. Bestücksystem nach Anspruch 13, wobei der erste Infrarot-Sender (7) mit dem zweiten Infrarot-Empfänger (10) und der erste Infrarot-Empfänger (9) mit dem zweiten Infrarot-Sender (8) über einen Lichtwellenleiter optisch gekoppelt sind.

15. Verfahren zur Datenübertragung von einer einem Bestückautomaten (11) zugeordneten ersten Steuereinrichtung (1) zu einer einer Zuführeinrichtung (12) zugeordneten zweiten Steuereinrichtung (2), wobei das Verfahren folgende Schritte aufweist:
- Umwandlung der von der ersten Steuereinrichtung (1) zu übertragenden Daten in entsprechende CAN-Protokoll konforme Daten mittels eines ersten CAN-Controllers (3), welcher der ersten Steuereinrichtung (1) zugeordnet ist;
- Umwandlung der CAN-Protokoll konformen Daten in entsprechende IrDA-Protokoll konforme Daten mittels eines ersten Protokoll-Wandlerbausteins (5), welcher mit dem ersten CAN-Controller verbunden ist;
- Umwandlung der IrDA-Protokoll konformen Daten in entsprechende optische Signale und deren Aussendung mittelseines ersten Infrarot-Senders (7), welcher mit dem ersten Protokoll-Wandlerbaustein elektrisch gekoppelt ist;
- Empfangen der optischen Signale und deren Rückumwandlung in entsprechende IrDA-Protokoll konforme Daten mittels eines zweiten Infrarot-Empfängers (10), welcher der Zuführeinrichtung (12) zugeordnet ist und mit dem ersten Infrarot-Sender (7) optisch gekoppelt ist;
- Umwandlung der IrDA-Protokoll konformen Daten in entsprechende CAN-Protokoll konforme Daten mittels eines zweiten Protokoll-Wandlerbausteins (6), welcher mit dem zweiten Infrarot-Empfänger (10) elektrisch gekoppelt ist;
- Umwandlung der CAN-Protokoll konformen Daten in entsprechende von der zweiten Steuereinrichtung (2) zu empfangende Daten mittels eines zweiten CAN-Controllers (4), welcher mit der zweiten Steuereinrichtung (2) zugeordnet ist und mit dem zweiten Protokoll-Wandlerbaustein (6) verbunden ist.

16. Verfahren zur Datenübertragung von einer einer Zuführeinrichtung (12) zugeordneten zweiten Steuereinrichtung (2) zu einer einem Bestückautomaten (11) zugeordneten ersten Steuereinrichtung (1), wobei das Verfahren folgende Schritte aufweist:
- Umwandlung der von der zweiten Steuereinrichtung (2) zu übertragenden Daten in entsprechende CAN-Protokoll konforme Daten mittels eines zweiten CAN-Controllers (4), welcher der zweiten Steuereinrichtung (2) zugeordnet ist;
- Umwandlung der CAN-Protokoll konformen Daten in entsprechende IrDA-Protokoll konforme Daten mittels eines zweiten Protokoll-Wandlerbausteins (6), welcher mit dem zweiten CAN-Controller (4) verbunden ist;
- Umwandlung der IrDA-Protokoll konformen Daten in entsprechende optische Signale und deren Aussendung mittels eines zweiten Infrarot-Senders (8), welcher mit dem zweiten Protokoll-Wandlerbaustein (6) elektrisch gekoppelt ist;
- Empfangen der optischen Signale und deren Rückumwandlung in entsprechende IrDA-Protokoll konforme Daten mittels eines ersten Infrarot-Empfängers (9), welcher dem Bestückautomaten (11) zugeordnet ist und mit dem zweiten Infrarot-Sender (8) optisch gekoppelt ist;
- Umwandlung der IrDA-Protokoll konformen Daten in entsprechende CAN-Protokoll konforme Daten mittels eines ersten Protokoll-Wandlerbausteins (5), welcher mit dem ersten Infrarot-Empfänger (9) elektrisch gekoppelt ist;
- Umwandlung der CAN-Protokoll konformen Daten in entsprechende von der ersten Steuereinrichtung (1) zu empfangende Daten mittels eines ersten CAN-Controllers (3), welcher mit der ersten Steuereinrichtung (1) zugeordnet ist und mit dem ersten Protokoll-Wandlerbaustein (5) verbunden ist.

## Claims

1. Component mounting apparatus (11) for equipping substrates with electrical components, with
- a first control unit (1) to which a first CAN controller (3) is assigned,
- a first protocol converter module (5), which is electrically connected to the first CAN controller (3) in order to convert IrDA protocol-conformant data into CAN protocol-conformant data and CAN protocol-conformant data into IrDA protocol-conformant data;
- a first infrared transmitter (7) and a first IrDA-conformant infrared receiver (9), which are both electrically coupled to the first protocol converter module (5) ;
- in which case the first infrared transmitter (7) can optically be coupled to a second infrared receiver (10), to which a feeding apparatus (12) for the electrical components is assigned, and the first infrared receiver (9) can optically be coupled to a second infrared transmitter (8), to which the feeding apparatus (12) is assigned.

2. Component mounting apparatus (11) in accordance with claim 1, further **characterised by**
- a first magnetic core (17), which is concentrically surrounded by a primary coil (16), which is electrically connected to a voltage supply (21) which is assigned to the component mounting apparatus (11),
- in which case the magnetic core (17) is arranged in such a way that it can be coupled to a second magnetic core (20) which is assigned to the feeding apparatus (12), which is concentrically surrounded by a secondary coil (19), and the first magnetic core (17) is mounted elastically in relation to the component mounting apparatus (11) so that the first magnetic core (17) will be pressed against the second magnetic core (20) in the coupled state.

3. Component mounting apparatus (11) in accordance with claim 2, **characterised in that** the first magnetic core (17) is in addition mounted rotatably so that mutually facing contact areas of the first magnetic core and of the second magnetic core (17, 20) lie in parallel against one another in the pressed state.

4. Component mounting apparatus (11) in accordance with one of the claims 2 to 3, **characterised in that** the first magnetic core (17) is embodied so narrowly that it does not exceed the width of the feeding apparatus (12), and that it in ranges where it is concentrically surrounded by the primary coil (16), together with the primary coil (16) does not exceed the width of the feeding apparatus (12).

5. Component mounting apparatus (11) in accordance with claim 4, **characterised in that** the first magnetic core (17) takes an E-shaped shape, the middle leg (27) of which is concentrically surrounded by the primary coil (16).

6. Component mounting apparatus (11) in accordance with claim 5, **characterised in that** the rear part (32) of the first magnetic core (17) connecting the three legs is at least embodied so narrow within the area of the extension of the middle leg (27) at least on one side of the first magnetic core (17) to be flush with the middle leg (27) in order to route the connecting cables (33) of the primary coil (16) there.

7. Feeding apparatus (12) for electrical components with
- a second control unit (2), to which a second CAN controller (4) is assigned,
- a second protocol converter module (6), which is electrically connected to the second CAN controller, in order to convert second IrDA protocol-conformant data into CAN protocol-conformant data and CAN protocol-conformant data into IrDA protocol-conformant data;
- a second infrared transmitter (8) and a second IrDA-conformant infrared receiver (10), which are both electrically coupled to the second protocol converter module (6);
- with the second infrared transmitter (8) able to be optically coupled to a first infrared receiver (9), to which a component mounting apparatus (11) is assigned, and the second infrared receiver (10) able to be optically coupled to a first infrared transmitter (7), to which the component mounting apparatus (11) is assigned.

8. Feeding apparatus (12) in accordance with claim 7, further **characterised by**
- a feeding apparatus housing (23),
- a second magnetic core (20), which is concentrically surrounded by a secondary coil (19), which is electrically connected to an electrical consumer (22) which is assigned to the feeding apparatus (12),
- with the second magnetic core (20) being arranged in such a way that it can be connected to a first magnetic core (17) which is assigned to a component mounting apparatus (11), said magnetic core which for its part being concentrically surrounded by a primary coil (16), and the second magnetic core (20) being mounted elastically relative to the feeding apparatus housing (23) so that the second magnetic core (20) will be pressed against the first magnetic core (17) in the coupled state.

9. Feeding apparatus (12) in accordance with one of the claims 7 to 8, **characterised in that** the second magnetic core (20) is in addition mounted rotatably, so that contact areas of the first magnetic core and of the second magnetic core (17), (20) which face each other always lie in parallel against one another in the pressed state.

10. Feeding apparatus (12) in accordance with one of the claims 7 to 9, **characterised in that** the second magnetic core (20) is embodied narrow enough not exceed the width of the feeding apparatus housing (23) and that in areas where it is concentrically surrounded by the secondary coil (19), along with the secondary coil (19) it does not exceed the width of the feeding apparatus housing (23).

11. Feeding apparatus (12) in accordance with claim 10, **characterised in that** the second magnetic core (20) has an E shape, the middle leg (27) of which is concentrically surrounded by the secondary coil (19).

12. Feeding apparatus (12) in accordance with claim 11, **characterised in that** the rear part (32) of the second magnetic core (20) connecting the three legs is at least configured narrow enough within the area of the extension of the middle leg (27) at least on one side of the second magnetic core (20) to be flush with the middle leg (27) in order to route the connecting cables (33) of the secondary coil (19) there.

13. Mounting system with a component mounting apparatus (11) in accordance with one of the claims 1 to 6 and at least one feeding apparatus (12) coupled to the component mounting apparatus (11) in accordance with one of the claims 7 to 12, with the first infrared transmitter (7) being optically coupled to the second infrared receiver (10) and the first infrared receiver (9) to the second infrared transmitter (8).

14. Mounting system in accordance with claim 13, with the first infrared transmitter (7) being optically coupled to the second infrared receiver (10) and the first infrared receiver (9) to the second infrared transmitter (8) by means of fibre optic cables.

15. Method for data transfer from a first control unit (1), which is assigned to a component mounting apparatus (11), to a second control unit (2), which is assigned to a feeding apparatus (12), with the method having the following steps:
- Conversion of the data to be transferred from the first control unit (1) into appropriate CAN protocol-conformant data by means of a first CAN controller (3), which is assigned to the first control unit (1);
- Conversion of the CAN protocol-conformant data into appropriate IrDA protocol-conformant data by means of a first protocol converter module (5), which is connected to the first CAN controller;
- Conversion of the IrDA protocol-conformant data into appropriate optical signals and their sending by means of a first infrared transmitter (7), which is electrically coupled to the first protocol converter module;
- Receiving of the optical signals and their transformation back into appropriate IrDA protocol-conformant data by means of a second infrared receiver (10), which is assigned to the feeding apparatus (12) and is optically coupled to the first infrared transmitter (7);
- Conversion of the IrDA protocol-conformant data into appropriate CAN protocol-conformant data by means of a second protocol converter module (6), which is electrically coupled to the second infrared receiver (10);
- Conversion of the CAN protocol-conformant data into appropriate data to be received from the second control unit (2) by means of a second CAN controller (4), which is assigned to the second control unit (2) and connected to the second protocol converter module (6).

16. Method for data transfer from a second control unit (2), which is assigned to a feeding apparatus (12), to a first control unit (1), which is assigned to a component mounting apparatus (11), with the method having the following steps:
- Conversion of the data to be transferred from the second control unit (2) into appropriate CAN protocol-conformant data by means of a second CAN controller (4), which is assigned to the second control unit (2);
- Conversion of the CAN protocol-conformant data into appropriate IrDA protocol-conformant data by means of a second protocol converter module (6), which is connected to the second CAN controller (4);
- Conversion of the IrDA protocol-conformant data into appropriate optical signals and their sending by means of a second infrared transmitter (8), which is electrically coupled to the second protocol converter module (6);
- Receiving of the optical signals and their back transformation into appropriate IrDA protocol-conformant data by means of a first infrared receiver (9), which is assigned to the component mounting apparatus (11) and is optically coupled to the second infrared transmitter (8);
- Conversion of the IrDA protocol-conformant data into appropriate CAN protocol-conformant data by means of a first protocol converter module (5), which is electrically coupled to the first infrared receiver (9);
- Conversion of the CAN protocol-conformant data into appropriate data to be received from the first control unit (1) by means of a first CAN controller (3), which is assigned to the first control unit (1) and connected to the first protocol converter module (5).

## Revendications

1. Automate de montage (11) pour l'équipement de substrats en composants électriques, comprenant
- un premier dispositif de commande (1) auquel est associé un premier contrôleur CAN (3),
- un premier module convertisseur de protocole (5) relié électriquement au premier contrôleur CAN (3) pour convertir des données conformes au protocole IrDA en données conformes au protocole CAN et des données conformes au protocole CAN en données conformes au protocole IrDA ;
- un premier émetteur infrarouge (7) et un premier récepteur infrarouge (9) compatible IrDA, les deux étant couplés électriquement au premier module convertisseur de protocole (5) ;
- le premier émetteur infrarouge (7) pouvant être couplé optiquement à un second récepteur infrarouge (10) lequel est associé à un dispositif d'alimentation (12) pour modules électriques, et le premier récepteur infrarouge (9) pouvant être couplé optiquement à un second émetteur infrarouge (8) lequel est associé au dispositif d'alimentation (12).

2. Automate de montage (11) selon la revendication 1,
**caractérisé en outre par**
- un premier noyau magnétique (17) qui est entouré par une bobine primaire (16) laquelle est reliée électriquement à une source de tension (21) associée à l'automate de montage (11),
- le premier noyau magnétique (17) étant disposé de telle sorte qu'il puisse être couplé à un second noyau magnétique (20) associé au dispositif d'alimentation (12) et entouré par une bobine secondaire (19), et le premier noyau magnétique (17) étant monté à ressort par rapport à l'automate de montage (11), de sorte que le premier noyau magnétique (17), à l'état couplé, est serré contre le second noyau magnétique (20).

3. Automate de montage (11) selon la revendication 2, **caractérisé en ce que** premier noyau magnétique (17) est en outre monté de façon à pouvoir tourner, de sorte que des surfaces de contact tournées l'une vers l'autre des premier et second noyaux magnétiques (17, 20) sont, à l'état serré, appliquées parallèlement l'une contre l'autre.

4. Automate de montage (11) selon l'une des revendications 2 à 3, **caractérisé en ce que** le premier noyau magnétique (17) est conçu de manière tellement étroite qu'il ne dépasse pas la largeur du dispositif d'alimentation (12) et que dans les parties où il est entouré par la bobine primaire (16), il ne dépasse pas, ensemble avec ladite bobine primaire (16), la largeur du dispositif d'alimentation (12).

5. Automate de montage (11) selon la revendication 4, **caractérisé en ce que** le premier noyau magnétique (17) présente une forme en E, dont la branche du milieu (27) est entourée par la bobine primaire (16).

6. Automate de montage (11) selon la revendication 5, **caractérisé en ce que** la partie dorsale (32) reliant les trois branches du premier noyau magnétique (17) est conçue de manière tellement étroite, au moins au niveau de la prolongation de la branche du milieu (27), qu'elle est au moins sur un côté du premier noyau magnétique (17) au même niveau que la branche du milieu (27) afin de guider à cet endroit des lignes de raccordement (33) de la bobine primaire (16).

7. Dispositif d'alimentation (12) pour composants électriques, comprenant
- un second dispositif de commande (2) auquel est associé un second contrôleur CAN (4),
- un second module convertisseur de protocole (6) relié électriquement audit second contrôleur CAN et pour convertir des secondes données conformes au protocole IrDA en données conformes au protocole CAN et des données conformes au protocole CAN en données conformes au protocole IrDA ;
- un second émetteur infrarouge (8) et un second récepteur infrarouge (10) compatible IrDA, les deux étant couplés électriquement au second module convertisseur de protocole (6);
- le second émetteur infrarouge (8) pouvant être couplé optiquement à un premier récepteur infrarouge (9) lequel est associé à un automate de montage (11), et le second récepteur infrarouge (10) pouvant être couplé optiquement à un premier émetteur infrarouge (7) lequel est associé à l'automate de montage (11).

8. Dispositif d'alimentation (12) selon la revendication 7, **caractérisé en outre par**
- un boîtier (23) du dispositif d'alimentation,
- un second noyau magnétique (20) qui est entouré par une bobine secondaire (19) laquelle est reliée électriquement à un consommateur électrique (22) associé au dispositif d'alimentation (12),
- le second noyau magnétique (20) étant disposé de telle sorte qu'il puisse être couplé à un premier noyau magnétique (17) associé à un automate de montage (11) et entouré par une bobine primaire (16), et le second noyau magnétique (20) étant monté à ressort par rapport au boîtier (23) du dispositif d'alimentation, de sorte que le second noyau magnétique (20), à l'état couplé, est serré contre le premier noyau magnétique (17).

9. Dispositif d'alimentation (12) selon l'une des revendications 7 à 8, **caractérisé en ce que** le second noyau magnétique (20) est en outre monté de façon à pouvoir tourner, de sorte que des surfaces de contact tournées l'une vers l'autre des premier et second noyaux magnétiques (17, 20) sont, à l'état serré, appliquées parallèlement l'une contre l'autre.

10. Dispositif d'alimentation (12) selon l'une des revendications 7 à 9, **caractérisé en ce que** le second noyau magnétique (20) est conçu de manière tellement étroite qu'il ne dépasse pas la largeur du boîtier (23) du dispositif d'alimentation et que dans les parties où il est entouré par la bobine secondaire (19), il ne dépasse pas, ensemble avec ladite bobine secondaire (19), la largeur du boîtier (23) du dispositif d'alimentation.

11. Dispositif d'alimentation (12) selon la revendication 10, **caractérisé en ce que** le second noyau magnétique (20) présente une forme en E, dont la branche du milieu (27) est entourée par la bobine secondaire (19).

12. Dispositif d'alimentation (12) selon la revendication 11, **caractérisé en ce que** la partie dorsale (32) reliant les trois branches du second noyau magnétique (20) est conçue de manière tellement étroite, au moins au niveau de la prolongation de la branche du milieu (27), qu'elle est au moins sur un côté du second noyau magnétique (20) au même niveau que la branche du milieu (27) afin de guider à cet endroit des lignes de raccordement (33) de la bobine secondaire (19).

13. Système de montage comprenant un automate de montage (11) selon l'une des revendications 1 à 6 et au moins un dispositif d'alimentation (12) couplé audit automate de montage (11) selon l'une des revendications 7 à 12, le premier émetteur infrarouge (7) étant couplé optiquement au second récepteur infrarouge (10) et le premier récepteur infrarouge (9) étant couplé optiquement au second émetteur infrarouge (8).

14. Système de montage selon la revendication 13, le premier émetteur infrarouge (7) étant couplé optiquement au second récepteur infrarouge (10) et le premier récepteur infrarouge (9) au second émetteur infrarouge (8) par l'intermédiaire d'un guide d'ondes optiques.

15. Procédé de transfert de données depuis un premier dispositif de commande (1) associé à un automate de montage (11) vers un second dispositif de commande (2) associé à un dispositif d'alimentation (12), le procédé comportant les étapes suivantes :
- conversion des données à transférer par le premier dispositif de commande (1) en données correspondantes conformes au protocole CAN au moyen d'un premier contrôleur CAN (3) associé au premier dispositif de commande (1) ;
- conversion des données conformes au protocole CAN en données correspondantes conformes au protocole IrDA au moyen d'un premier module convertisseur de protocole (5) relié au premier contrôleur CAN ;
- conversion des données conformes au protocole IrDA en signaux optiques correspondants et émission de ceux-ci au moyen d'un premier émetteur infrarouge(7,couplé électriquement, au premier module convertisseur de protocole ;
- réception des signaux optiques et reconversion de ceux-ci en données correspondantes conformes au protocole IrDA au moyen d'un second récepteur infrarouge (10) associé au dispositif d'alimentation (12) et couplé optiquement au premier émetteur infrarouge (7) ;
- conversion des données conformes au protocole IrDA en données conformes au protocole CAN au moyen d'un second module convertisseur de protocole (6) couplé électriquement au second récepteur infrarouge (10) ;
- conversion des données conformes au protocole CAN en données correspondantes à recevoir par le second dispositif de commande (2) au moyen d'un second contrôleur CAN (4) associé au second dispositif de commande (2) et relié au second module convertisseur de protocole (6).

16. Procédé de transfert de données depuis un second dispositif de commande (2) associé à un dispositif d'alimentation (12) vers un premier dispositif de commande (1) associé à un automate de montage (11), le procédé comportant les étapes suivantes :
- conversion des données à transférer par le second dispositif de commande (2) en données correspondantes conformes au protocole CAN au moyen d'un second contrôleur CAN (4) associé au deuxième dispositif de commande (2) ;
- conversion des données conformes au protocole CAN en données correspondantes conformes au protocole IrDA au moyen d'un second module convertisseur de protocole (6) relié au second contrôleur CAN (4) ;
- conversion des données conformes au protocole IrDA en signaux optiques correspondants et émission de ceux-ci au moyen d'un second émetteur infrarouge (8) couplé électriquement au second module convertisseur de protocole (6) ;
- réception des signaux optiques et reconversion de ceux-ci en données correspondantes conformes au protocole IrDA au moyen d'un premier récepteur infrarouge (9) associé à l'automate de montage (11) et couplé optiquement au second émetteur infrarouge (8) ;
- conversion des données conformes au protocole IrDA en données conformes au protocole CAN au moyen d'un premier module convertisseur de protocole (5) couplé électriquement au premier récepteur infrarouge (9) ;
- conversion des données conformes au protocole CAN en données correspondantes à recevoir par le premier dispositif de commande (1) au moyen d'un premier contrôleur CAN (3) associé au premier dispositif de commande (1) et relié au premier module convertisseur de protocole (5).
